Europäisches Patentamt

European Patent Office

Office européen des brevets

(19)

(11) Veröffentlichungsnummer: **0 283 545 B1**

(12) **EUROPÄISCHE PATENTSCHRIFT**

(45) Veröffentlichungstag der Patentschrift: **16.10.91**

(51) Int. Cl.⁵: **G01R 1/073**

(21) Anmeldenummer: **87104577.9**

(22) Anmeldetag: **27.03.87**

(54) **Kontaktsonden-Anordnung zur elektrischen Verbindung einer Prüfeinrichtung mit den kreisförmigen Anschlussflächen eines Prüflings.**

(43) Veröffentlichungstag der Anmeldung:
**28.09.88 Patentblatt 88/39**

(45) Bekanntmachung des Hinweises auf die
Patenterteilung:
**16.10.91 Patentblatt 91/42**

(84) Benannte Vertragsstaaten:
**DE FR GB IT**

(56) Entgegenhaltungen:
**EP-A- 0 068 270**
**EP-A- 0 164 672**
**EP-A- 0 165 331**
**DE-A- 3 337 915**

(73) Patentinhaber: **IBM DEUTSCHLAND GMBH**
**Pascalstrasse 100**
**W-7000 Stuttgart 80(DE)**

(84) Benannte Vertragsstaaten:
**DE**

Patentinhaber: **International Business Machines Corporation**
**Old Orchard Road**
**Armonk, N.Y. 10504(US)**

(84) Benannte Vertragsstaaten:
**FR GB IT**

(72) Erfinder: **Bayer, Thomas**
**Hinterweiler Strasse 45,**
**W-7032 Sindelfingen(DE)**
Erfinder: **Elsässer, Michael**
**Spechtweg 14**
**W-7033 Herrenberg(DE)**
Erfinder: **Greschner, Johann, Dr.**
**Tiergartenweg 14**
**W-7401 Pliezhausen 1(DE)**

Erfinder: **Schmid, Heinrich**
**Blumenstrasse 29**
**W-7533 Tiefenbronn 1(DE)**
Erfinder: **Stöhr, Roland R.**
**Kniebisweg 2**
**W-7031 Nufringen(DE)**
Erfinder: **Wolter, Olaf, Dr.**
**Herdlauchring 43**
**W-7036 Schönaich(DE)**
Erfinder: **Wittlinger, Jürgen**
**Heusteigstrasse 34**
**W-7030 Böblingen(DE)**


(74) Vertreter: **Barth, Carl Otto et al**
**IBM Corporation Säumerstrasse 4**
**CH-8803 Rüschlikon(CH)**

**Beschreibung**

Die Erfindung betrifft eine Kontaktsonden-Anordnung zur elektrischen Verbindung einer Prüfeinrichtung mit den kreisförmigen Anschlußflächen eines Prüflings, deren Kontaktsonden zur Erzielung eines geringen Kontaktwiderstandes auf die Anschlußflächen gedrückt werden und sich zur Anpassung an durch Unebenheiten der Oberfläche des Prüflings bedingte Höhenunterschiede der Anschlußflächen seitlich ausbiegen.

Derartige Kontaktsonden-Anordnungen dienen beispielsweise der Prüfung von Leiterzugsnetzen auf Unterbrechungen und Kurzschlüsse, die in einem keramischen Substrat für das Aufnehmen von Halbleiterchips mit integrierten Schaltungen in mehreren Ebenen verlaufen und untereinander verbunden sind. So ist aus der europäischen Patentanmeldung 84 107 154 mit der Veröffentlichungsnummer 165 331 eine Kontaktsonden-Anordnung zum elektrischen Verbinden einer Prüfeinrichtung mit den Anschlußflächen eines Prüflings bekannt, bei der aus elektrisch gut leitendem, federndem Material bestehende Drähte als Kontaktsonden dienen. Die Kontaktsonden werden auf die Anschlußflächen des Prüflings aufgesetzt und zum Erzielen eines niedrigen Kontaktwiderstandes axial belastet. Dabei biegen sie sich seitlich aus. Dieses seitliche Ausbiegen ist erwünscht, da sich die Kontaktsonden dadurch durch Unebenheiten der Oberfläche des Prüflings bedingten Höhenunterschieden der Anschlußflächen anpassen können. Damit sich die Kontaktsonden alle zur gleichen Seite ausbiegen, werden sie durch drei in größerem Abstand übereinander angeordnete Lochplatten geführt. Die mittlere ist dabei leicht gegen die beiden anderen, genau fluchtenden, versetzt angebracht. Dadurch wird ein gegenseitiges Berühren der Kontaktsonden bei axialer Belastung verhindert, was durch Abreiben der jede Sonde umgebenden isolierenden Lackschicht zu Kurzschlüssen führen würde.

Der mit der bekannten Anordnung an den Berührungsstellen von Kontaktsonden und Anschlußflächen des Prüflings erzielbare geringe Kontaktwiderstand und ihr Anpassungsvermögen an Höhenunterschiede der Anschlußflächen des Prüflings ist wesentlich von der Höhe und Konstanz der axialen Belastung der Sonden abhängig. Die zulässige Axiallast wird durch das Material der Sonden, das durch die Härte, die Federsteife und den Elastizitätsmodul gekennzeichnet ist, sowie durch das als Formfaktor bezeichnete Verhältnis der Länge des senkrecht verlaufenden Teiles der Kontaktsonden zu ihrem Durchmesser begrenzt.

Aus EP-A-0164672 ist eine Kontaktsonden-Anordnung für Anschlüsse hoher Flächendichte bekannt. Die Kontaktsonden biegen sich innerhalb von Langlochplatten, die mit einem Abstand von einander angeordnet sind, Zwischen den Langlochplatten sind Lochplatten mit Führungs-Löchern angeordnet, deren Löcher keine seitliche Ausbiegung der Kontaktsonden erlauben.

Wenn aufgrund von Fortschritten bei der Herstellung monolithisch integrierter Halbleiterschaltungen die Dichte der pro Flächeneinheit realisierbaren Schaltungselemente steigt, verringert sich auch der Durchmesser der Anschlußflächen auf dem Substrat, das die Halbleiterschaltungen aufnimmt. Damit müssen auch Kontaktsonden geringeren Durchmessers für das Prüfen der Leiterzugsnetze in den Substraten verwendet werden. Dies bedeutet, daß sich die Kontaktsonden bei gleicher axialer Belastung stärker seitlich ausbiegen. Dies hat zur Folge, daß die Druckbeanspruchung der Sonden auf Kosten der Zunahme ihres seitlichen Ausbiegens zurückgeht. Damit ist aber der für zuverlässige Prüfergebnisse erforderliche geringe Kontaktwiderstand, der druckabhängig ist, nicht mehr gegeben.

Hier will die Erfindung Abhilfe schaffen. Die Erfindung, wie sie in den Ansprüchen gekennzeichnet ist, löst die Aufgabe, eine Kontaktsonden-Anordnung zur elektrischen Verbindung einer Prüfeinrichtung mit den kreisförmigen Anschlußflächen eines Prüflings zu schaffen, die trotz verringertem Durchmesser der Kontaktsonden den für zuverlässige Prüfergebnisse unerlässlichen geringen Kontaktwiderstand gewährleistet.

Im folgenden wird die Erfindung in Verbindung mit den Zeichnungen näher erläutert, von denen zeigen:

Fig. 1     einen Längsschnitt durch einen Ausschnitt aus dem unteren Teil der erfindungsgemäßen Kontaktsonden-Anordnung in ihrer Bereitschaftsstellung,

Fig. 2     einen Längsschnitt durch einen Ausschnitt aus dem unteren Teil der erfindungsgemäßen Kontaktsonden-Anordnung in ihrer Arbeitsstellung,

Fig. 3     eine vergrößerte Draufsicht auf einen Ausschnitt einer der als Kontaktsondenführungen bevorzugten Langlochplatten,

Fig. 4     eine Draufsicht auf zwei Langlöcher zweier gegeneinander versetzter Lochplatten, bei der die halbkreisförmigen Langlochkanten sich zu einem eine Kontaktsonde umschließenden Kreis ergänzen,

Fig. 5     ein Kraft-Weg-Diagramm, das den Zusammenhang zwischen der auf eine Kontaktsonde wirkenden Druckkraft und der durch das seitliche Ausbiegen der Kontaktsonde in Richtung ihrer Längsachse in unbelastetem Zustand bewirkten Verkürzung zeigt.

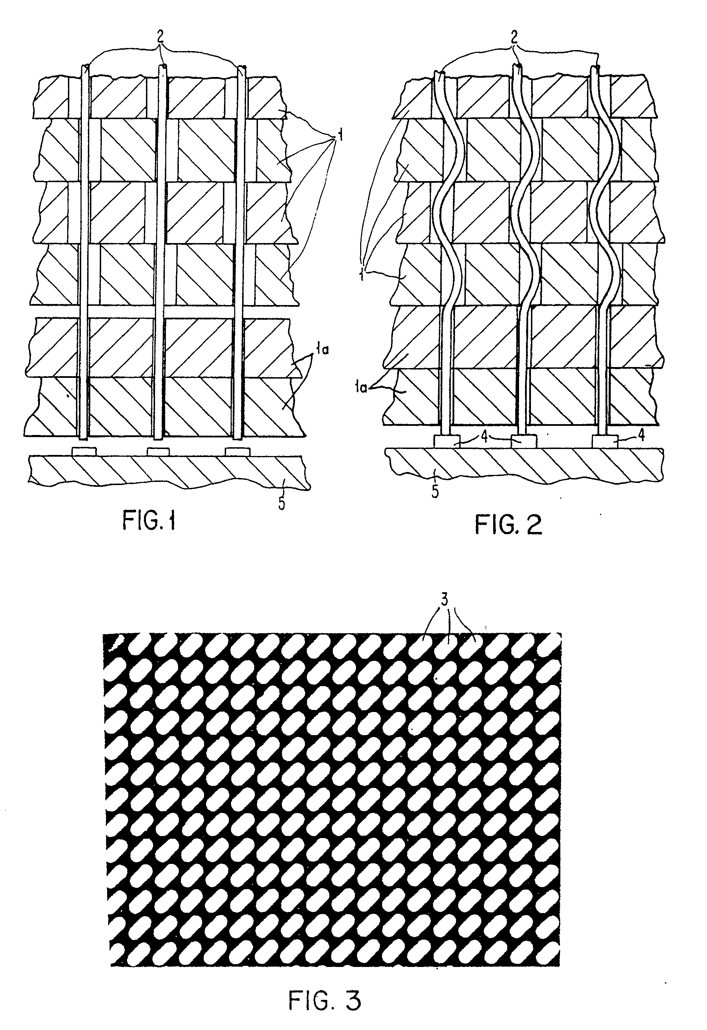

Wie aus der als Prinzipskizze dienenden Fig. 1 hervorgeht, besteht die neue Kontaktsonden-Anordnung aus einer Reihe aufeinandergestapelter Lochplatten 1 und 1a, durch die sich die Kontaktsonden 2 erstrecken. Die Lochplatten 1a werden auch als Lochplatten erster Art und die Lochplatten 1 als solche zweiter Art bezeichnet. Die Lochplatten 1a, die in senkrechter Richtung verschiebbar angeordnet sind, werden im Ruhezustand der Kontaktsonden-Anordnung durch zwischen der obersten Lochplatte 1a und der untersten Lochplatte 1, im Randbereich der Lochplatten angeordnete, nicht dargestellte schraubenförmige Druckfedern nach unten gedrückt, so daß die unteren Enden der Kontaktsonden 2 durch die Lochplatten 1a geschützt werden. Während letztere runde oder quadratische Führungslöcher für die Kontaktsonden aufweisen, sind die Lochplatten 1 vorzugsweise mit Langlöchern 3 versehen, wie die Draufsicht nach Fig. 3 zeigt. Die Lochplatten können jedoch auch mit lauter rechteckigen, quadratische, kreisförmigen, elliptischen oder trapezförmigen Löchern versehen sein.

Die aufeinandergeschichteten Lochplatten werden durch in Fig. 1 nicht dargestellte Schraubenbolzen zusammengehalten. Die Lochplatten 1 sind dabei so in dem Plattenstapel angeordnet, daß von jeweils drei aufeinander gestapelten Lochplatten 1 die mittlere so gegen die beiden anderen, miteinander fluchtenden versetzt ist, daß jede Kontaktsonde 2 von einem Teil der Lochunterkante der oberen und einem Teil der Lochoberkante der mittleren, sowie von einem Teil der Lochunterkante der mittleren und einem Teil der Lochoberkante der unteren Lochplatte umschlossen wird. Dadurch wird erreicht, daß sich die Kontaktsonde bei axialer Belastung höchstens bis zu dem ihr maximales Ausbiegen begrenzenden Teil der Lochwandung ausbiegen kann.

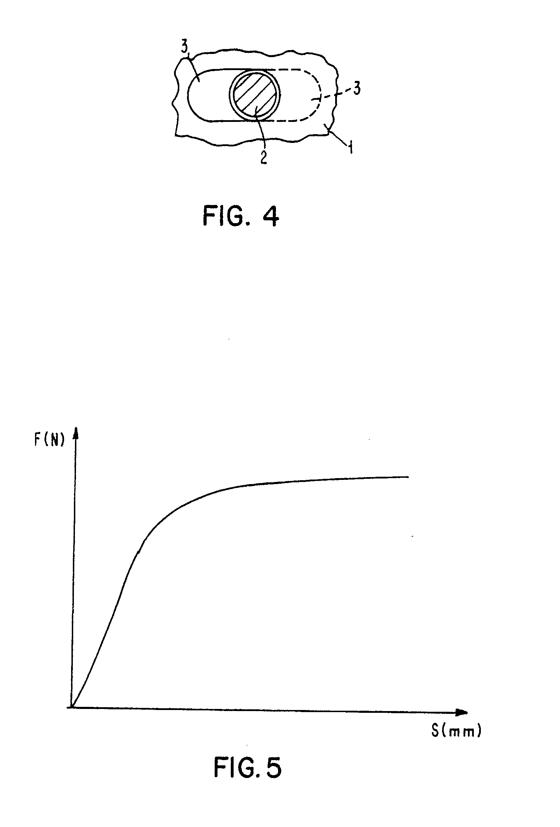

Bei der Verwendung der bevorzugten Lochplatten mit Langlöchern sind, wie das aus Fig. 4 hervorgeht, jeweils zwei übereinanderliegende Langlochplatten 1 so gegeneinander versetzt, daß sich das rechte Halbrund des Langlochs 3 der oberen Lochplatte und das linke Halbrund des Langlochs 3 der unteren Lochplatte überlappen. Dadurch wird erreicht, daß die Kontaktsonde 2 bei vertikaler Belastung sich in der Ebene, die durch die halbrunde Unterkante der oberen und die halbrunde Oberkante der unteren Langlochplatte 1 bestimmt ist, nicht seitlich ausbiegen kann. Sie kann es auch nicht in der Berührungsebene zwischen der unteren und der darunter befindlichen Langlochplatte 1, die mit der obersten fluchtet.

Diese Versetzung von zwei übereinanderliegenden Langlochplatten könnte dadurch erreicht werden, daß beide Langlochplatten gleich sind, aber eine um 180° gegenüber der zweiten gedreht ist.

Das seitliche Ausbiegen der Kontaktsonden 1 erfolgt daher in dem Raum zwischen der Ober-und Unterkante eines Langlochs 3. Begrenzt wird es jeweils durch eine der beiden halbrunden Lochwandlungen jedes Langlochs 3. Vorzugsweise beträgt die Längsachse jedes Langlochs das Doppelte des Durchmessers der Kontaktsonden. Bei den übrigen vorher erwähnten Lochformen ist bei den rechteckigen Löchern die große Seite, bei quadratischen die Seitenlänge, bei elliptischen die Hauptachse und bei trapezförmigen Löchern die Höhe des Trapezes so groß wie der doppelte Durchmesser der Kontaktsonden.

Für den Prüfvorgang wird die Kontaktsonden-Anordnung auf die Anschlußfläche 4 des in Fig. 2 angedeuteten Prüflings 5 abgesenkt. Sobald ihre unterste, in senkrechter Richtung verschiebbare Lochplatte 1 den Prüfling 5 berührt, wird sie gegen die Wirkung der schraubenförmigen Druckfeder nach oben bewegt und die unteren Enden der Kontaktsonden 2 für das Kontaktieren der Anschlußflächen 4 freigegeben. Weiteres Absenken der Kontaktsonden-Anordnung gegenüber dem unbeweglich angeordneten Prüfling 5 sorgt durch die dabei entstehende Druckbeanspruchung der Kontaktsonden 2 für den erforderlichen geringen Kontaktwiderstand zwischen den Kontaktsonden 2 und den Anschlußflächen 4 des Prüflings 5. Bei der senkrechten Druckbeanspruchung der Kontaktsonden 2 biegen sich diese wie in Fig. 2 dargestellt, seitlich aus.

Das seitliche Ausbiegen ist in der Mitte der Höhe jeder Lochplatte 1 am größten und wird im Falle der Verwendung von Langlochplatten jeweils durch die eine halbrunde Lochwand eines Langlochs 3 auf einen solchen Wert begrenzt, daß der für ein zuverlässiges Prüfergebnis erforderliche geringe Kontaktwiderstand zwischen den Kontaktsonden 2 und den Anschlußflächen 4 des Prüflings 5 noch sicher gewährleistet ist. Zur Anpassung an die durch Unebenheiten des Prüflings 5 bedingten Höhenunterschiede seiner Anschlußflächen 4 werden so viele Langlochplatten 1 aufeinander gestapelt, bis die Summe aller Verkürzungen, die eine Kontaktsonde 2 in den Löchern 3 in Richtung ihrer ursprünglichen Längsachse aufgrund der seitlichen Ausbiegungen erfährt, ausreicht, um sich den Höhenunterschieden anzupassen.

Bei dem in Abbildung 5 dargestellten Kraft-Weg-Diagramm, das den Zusammenhang zwischen der auf eine Kontaktsonde 2 wirkenden Druckkraft F und der durch das seitliche Ausbiegen der Kontaktsonde 2 in Richtung ihrer Längsachse im unbelasteten Zustand bewirkten Verkürzung wiedergibt, ist besonders der flach verlaufende Teil der Kurve interessant. Ihm läßt sich entnehmen, welchen Höhenunterschieden der Anschlußflächen 4 sich eine Kontaktsonde 2 bei nahezu gleichbleibender Druckkraft F anpassen kann. Durch Versuche wurde festgestellt, daß für den gewünschten Kurvenverlauf die Dicke der Lochplatten 1 eine entscheidende Größe ist. Bei einer Plattendicke von 2 mm wurde eine optimale Kurve erhalten. Die erforderliche Plattendicke läßt sich auch durch Aufbau jeder Lochplatte aus mehreren Teilplatten erzielen.

Um möglichst viele Kontaktsonden pro Flächeneinheit unterzubringen, empfiehlt es sich, die Längsachsen der Langlöcher 3 bzw. der rechteckigen, elliptischen und trapezförmigen Löcher unter einem Winkel von 45 bzw. 135° zur x-Koordinaten der Lochplatten verlaufen zu lassen.

Die beschriebene Kontaktsonden-Anordnung bietet außer der schon eingangs erwähnten Möglichkeit der Verwendung von Kontaktsonden geringeren Durchmessers eine Reihe weiterer Vorteile. Hier sind zu nennen: Das Anpassungsvermögen der Kontaktsonden-Anordnung an Höhenunterschiede der Anschlußflächen 4 des Prüflings 5 kann durch Erhöhen der Anzahl der Lochplatten 1 beliebig erhöht werden. Aufgrund des Lochplattenstapels können auch größere Druckkräfte auf die Kontaktsonden ausgeübt werden. Schließlich wird das Einfädeln der als Drähte ausgebildeten Kontaktsonden 2 durch den Lochplattenstapel dadurch beträchtlich vereinfacht, daß beim Einfädeln die Lochplatten 1 nicht gegeneinander versetzt sind und die gesamte Lochfläche für das Einfädeln der Kontaktsonden 2 zur Verfügung steht. Erst danach werden die Lochplatten 1 gegeneinander versetzt und in dieser Lage durch den Schraubenbolzen fixiert.

Aufgrund ihres konstruktiven Aufbaus entstehen bei der Kontaktsonden-Anordnung nach der Erfindung im Gegensatz zu der in der Beschreibungseinleitung erwähnten Prüfeinrichtung nach dem Stand der Technik keine erheblichen, quer zur Achse der Kontaktsonden 2 verlaufenden Kräfte, die durch aufwendige mechanische Halterungen aufgefangen werden müßten. Bei der erfindungsgemäßen Kontaktsonden-Anordnung kompensieren sich die auftretenden Querkräfte jeweils innerhalb zweier Lochplatten 1, da sich eine Kontaktsonde 2 zum Beispiel im Langloch 3 der oberen Platte 1 etwa rechts und in dem der darunterliegenden Lochplatte nach links ausbiegt.

## Patentansprüche

1. Kontaktsonden-Anordnung zum elektrischen Verbinden einer Prüfeinrichtung mit den kreisförmigen Anschlussflächen eines Prüflings, deren Kontaktsonden zum Erzielen eines geringen Kontaktwiderstandes senkrecht auf die Anschlussflächen gedrückt werden und sich zur Anpassung an durch Unebenheiten der Oberfläche des Prüflings bedingte Höhenunterschiede der Anschlussflächen seitlich ausbiegen,

   dadurch gekennzeichnet,

   daß die Kontaktsonden (2) unterhalb einer Einbettung in eine Kunststoffmasse durch aufeinander gestapelte, als Führungsplatten für sie dienende Lochplatten (1, 1a) verlaufen,

   daß der Lochplattenstapel aus zwei Arten von Lochplatten besteht, von denen die erste die untersten Lochplatten (1a) umfaßt, deren Löcher so geformt sind, daß sie ein senkrechtes Aufsetzen der Kontaktsonden (2) auf die Anschlussflächen (4) des Prüflings (5) sicherstellen,

   daß von jeweils drei aufeinander gestapelten Lochplatten (1) der zweiten Art die mittlere so gegen die beiden anderen, miteinander fluchtenden versetzt ist, daß jede Kontaktsonde (2) von einem Teil der Lochunterkante der oberen und einem Teil der Lochoberkante der mittleren sowie von einem Teil der Lochunterkante der mittleren und einem Teil der Lochoberkante der unteren Lochplatte umschlossen wird, derart, daß sich die Kontaktsonde bei axialer Belastung höchstens bis zu dem ihr maximales Ausbiegen begrenzenden Teil der Lochwandung ausbiegen kann.

2. Kontaktsonden-Anordnung nach Anspruch 1, dadurch gekennzeichnet,

   daß alle Lochplatten einer Art untereinander gleich sind.

3. Kontaktsonden-Anordnung nach Anspruch 1, dadurch gekennzeichnet,

   daß die Lochplatten erster Art Rundlöcher bzw. quadratische Löcher aufweisen, und

   daß der Durchmesser der Rundlöcher bzw. die Seitenlänge der quadratischen Löcher nur geringfügig grösser als der Durchmesser der Kontaktsonden ist.

4. Kontaktsonden-Anordnung nach Anspruch 1, dadurch gekennzeichnet,

   daß die Lochplatten zweiter Art Langlöcher bzw. rechteckige bzw. quadratische bzw. kreisförmige bzw. elliptische bzw. trapezförmige Löcher aufweisen.

5. Kontaktsonden-Anordnung nach Anspruch 1,

dadurch gekennzeichnet,

daß die untere bzw. obere von zwei aufeinander gestapelten mit Langlöchern bzw. rechteckigen, bzw. quadratischen bzw. kreisförmigen bzw. elliptischen bzw. trapezförmigen Löchern versehenen Lochplatten der zweiten Art eine der oberen bzw. unteren gleiche, jedoch um 180° ihr gegenüber gedrehte, ist.

6. Kontaktsonden-Anordnung nach Anspruch 1, dadurch gekennzeichnet,

daß die Längsachsen der Langlöcher bzw. die längeren Seiten der rechteckigen bzw. die großen Achsen der elliptischen bzw. die Symmetrieachsen der trapezförmigen Löcher der Lochplatten zweiter Art unter 45° bzw. 135° zur X-Achse verlaufen.

7. Kontaktsonden-Anordnung nach Anspruch 1, dadurch gekennzeichnet,

daß bei den Lochplatten zweiter Art die Längsachsen der Langlöcher bzw. die großen Rechteckseiten der rechteckigen bzw. die Seitenlänge der quadratischen bzw. der Durchmesser der kreisförmigen bzw. große Achse der elliptischen bzw. die Höhe des Trapezes der trapezförmigen Löcher mindestens gleich dem doppelten Durchmesser der Kontaktsonden ist.

8. Kontaktsonden-Anordnung nach Anspruch 1, dadurch gekennzeichnet,

daß jede Lochplatte aus mehreren Teillochplatten zusammengesetzt ist.

9. Kontaktsonden-Anordnung nach Anspruch 1, dadurch gekennzeichnet,

daß die Lochplatten erster Art in senkrechter Richtung verschiebbar sind.

10. Kontaktsonden-Anordnung nach Anspruch 1, dadurch gekennzeichnet,

daß die Dicke der Lochplatten 2 mm beträgt.

## Claims

1. Contact probe arrangement for electrically connecting a test system with the circular contact pads of a device to be tested, the contact probes, for ensuring a low contact resistance, being pressed vertically onto the contact pads and buckling laterally in order to adapt to height differences of the contact pads caused by irregularities of the surface of the device to be tested,

characterized in that

the contact probes (2) extend from their embedding in synthetic material through stacked perforated plates (1, 1a) serving as their guiding plates,

that the stack of perforated plates consists of two kinds of plates, the first comprising the lowermost perforated plates (1a) whose perforations are shaped in such a manner that they permit the contact probes (2) to be vertically placed onto the contact pads (4) of the device to be tested,

that of three respective stacked perforated plates (1) of the second kind the middle one is offset against the two others which are aligned relative to each other, in such a manner that each contact probe (2) is surrounded by part of the lower edge of the upper perforation plate and part of the upper edge of the middle perforation plate, as well as by part of the lower edge of the middle perforation plate and part of the upper edge of the lower perforation plate, in such a manner that upon the application of axial pressure the contact probe can buckle only to a part of the perforation wall limiting its maximum buckling.

2. Contact probe arrangement as claimed in claim 1,
characterized in that all perforated plates of one kind are alike relative to each other.

3. Contact probe arrangement as claimed in claim 1,
characterized in that the contact plates of the first kind have circular or square holes, and that the diameter of the circular holes, or the side length of the square holes is only slightly bigger than the diameter of the contact probe.

4. Contact probe arrangement as claimed in claim 1,
characterized in that the perforated plates of the second kind have oblong holes or rectangular or square or circular or elliptical or trapezoidal holes, respectively.

5. Contact probe arrangement as claimed in claim 1,
characterized in that the lower or upper one of two stacked perforated plates with oblong holes or rectangular or square or circular or elliptical or trapezoidal holes, respectively, of the second kind is like the upper or the lower one, respectively, but turned by 180° relative thereto.

6. Contact probe arrangement as claimed in claim 1,
characterized in that the longitudinal axes of the oblong holes, or the longer sides of the rectangular holes, or the big axes of the elliptical holes, or the symmetry axes of the trapezoidal holes of the perforated plates of the second kind are at 45° or 135° to the X-axis.

7. Contact probe arrangement as claimed in claim 1,
characterized in that in the perforated plates of the second kind the longitudinal axes of the oblong holes, or the longer sides of the rectangular holes, or the side length of the square holes, or the diameter of the circular holes, or the long axis of the elliptical holes or the trapezoid height of the trapezoidal holes, at least equal twice the diameter of the contact probes.

8. Contact probe arrangement as claimed in claim 1,
characterized in that each perforated plate is composed of a plurality of perforated part plates.

9. Contact probe arrangement as claimed in claim 1,
characterized in that the perforated plate of the first kind is shiftable in vertical direction.

10. Contact probe arrangement as claimed in claim 1,
characterized in that the thickness of the perforated plates is 2 mm.

**Revendications**

1. Dispositif à sondes de contact pour raccorder électriquement un dispositif d'essai aux surfaces circulaires de raccordement d'un spécimen, et dont on applique les sondes de contact perpendiculairement sur les surfaces de raccordement, pour obtenir une faible résistance de contact, les sondes de contact fléchissant latéralement de manière à s'adapter à des différences de hauteur des surfaces de raccordement, dues à des inégalités de la surface du spécimen,
caractérisé par le fait
que les sondes de contact (2) traversent, au-dessous d'une masse d'enrobage en matière plastique, des plaques perforées empilées (1,1a), utilisées comme plaques de guidage pour les sondes,
que la pile de plaques perforées est constituée de deux types de plaques perforées, dont le premier comprend les plaques perforées (1a) situées au niveau le plus bas et dont les trous sont agencés de manière à garantir une application verticale des sondes de contact (2) sur les surfaces de raccordement (4) du spécimen (5),
que parmi respectivement trois plaques perforées empilées (1) du second type, la plaque médiane est décalée par rapport aux deux autres plaques, alignées entre elles, de manière que chaque sonde de contact (2) est entourée par une partie du bord inférieur du trou de la plaque perforée supérieure et par une partie du bord supérieur du trou de la plaque médiane perforée ainsi que par une partie du bord inférieur du trou de la plaque médiane perforée et par une partie du bord supérieur du trou de la plaque inférieure perforée, de sorte que, lors de l'application d'une charge axiale, la sonde de contact peut fléchir au maximum jusqu'à la partie de la paroi du trou, qui limite son fléchissement maximum.

2. Dispositif à sondes de contact selon la revendication 1, caractérisé en ce
que toutes les plaques perforées d'un type sont identiques.

3. Dispositif à sondes de contact selon la revendication 1, caractérisé en ce
que les plaques perforées du premier type possèdent des trous circulaires ou des trous carrés, et
que le diamètre des trous circulaires ou la longueur des côtés des trous carrés est seulement légèrement supérieure au diamètre des sondes de contact.

4. Dispositif à sondes de contact selon la revendication 1, caractérisé en ce
que les plaques perforées du second type comportent des trous allongés ou des trous rectangulaires ou carrés ou circulaires ou elliptiques ou trapézoïdaux.

5. Dispositif à sondes de contact selon la revendication 1, caractérisé en ce
que la plaque inférieure ou la plaque supérieure de deux plaques perforées du second type, superposées, comportant des trous allongés ou des trous rectangulaires carrés ou circulaires ou elliptiques ou trapézoïdaux, est identique à l'une des plaques supérieure ou inférieure, mais est pivotée de 180° par rapport à cette plaque.

6. Dispositif à sondes de contact selon la revendication 1, caractérisé en ce que les axes longitudinaux des trous allongés ou les grands côtés des trous rectangulaires ou les grands axes des trous elliptiques ou les axes de symétrie des trous trapézoïdaux des plaques perforées du second type sont inclinés de 45° ou de 135° par rapport à l'axe X.

7. Dispositif à sondes de contact selon la revendication 1, caractérisé en ce que, dans le cas des plaques perforées du second type, les axes longitudinaux des trous allongés ou les grands côtés des trous rectangulaires ou les longueurs des côtés des trous carrés ou le diamètre des trous circulaires ou le grand axe des trous elliptiques ou la hauteur du trapèze des trous trapézoïdaux sont au moins égaux au double du diamètre des sondes de contact.

8. Dispositif à sondes de contact selon la revendication 1, caractérisé en ce que chaque plaque perforée est formée par la réunion de plusieurs plaques perforées partielles.

9. Dispositif à sondes de contact selon la revendication 1, caractérisé en ce que les plaques perforées du premier type peuvent être déplacées dans une direction perpendiculaire.

10. Dispositif à sondes de contact selon la revendication 1, caractérisé en ce que l'épaisseur des plaques perforées est égale à 2 mm.

FIG. 1

FIG. 2

FIG. 3

FIG. 4

FIG. 5